# NEUE EUROPÄISCHE PATENTSCHRIFT

(11) **EP 0 669 711 B2**
(45) Veröffentlichungstag und Bekanntmachung des Hinweises auf die Entscheidung über den Einspruch: **15.02.2006**
(45) Hinweis auf die Patenterteilung: 18.04.2001
(21) Anmeldenummer: 95101103.0
(22) Anmeldetag: 27.01.1995
(51) Int. Cl.: H03G 3/32, H03G 5/16

(54) **Autoradio-Tonwiedergabeeinrichtung mit einer störgeräuschabhängigen Lautstärkesteuerung**
Car radio sound reproduction apparatus with noise dependent volume control
Dispositif de reproduction du son pour autoradio avec commande de volume en fonction du niveau de bruit ambiant

(30) Priorität: 26.02.1994 DE 4406352
(43) Veröffentlichungstag der Anmeldung: 30.08.1995
(73) Patentinhaber: ROBERT BOSCH GMBH, 70442 Stuttgart (DE)
(72) Erfinder: Blum, Peter, D-30459 Hannover (DE)
(74) Vertreter: Bee, Joachim

(56) Entgegenhaltungen:
- DE-A- 4 038 805
- DE-A1- 3 733 832
- DE-C- 3 816 918
- DE-C3- 2 456 468
- US-A- 5 034 984
- US-A- 5 204 971

## Beschreibung

Die Erfindung betrifft eine Autoradio-Tonwiedergabeeinrichtung in der externe Störgeräusche kompensiert werden.

Um beim Betrieb eines Autoradios die Motor- und Fahrgeräusche eines Kraftfahrzeuges zu verdekken, erhöht man im allgemeinen die Verstärkung des Nutzsignals. Dieses kann durch eine automatische Lautstärkesteuerung in Abhängigkeit von einem störgeräuschabhängigen Störsignal erfolgen.

Bei einer aus der DOS 2 310 562 bekannten Schaltungsanordnung werden u. a. dem Drehzahlmesser des Motors und/oder dem Geschwindigkeitsmesser des Kraftfahrzeuges entnehmbare Signale zur Lautstärkesteuerung verwendet. Dabei wird jedoch das gesamte Tonfrequenzspektrum angehoben, also auch diejenigen Frequenzen, in deren Bereich Störsignale überhaupt nicht vorhanden sind. Dieses führt zu einer Überbetonung der Frequenzbereiche, in denen die Störung gering oder nicht vorhanden ist. Dadurch werden die in diesen Frequenzbereichen verstärkten Nutzsignalanteile als störend empfunden, so daß sie wiederum zu einer Verminderung der Verständlichkeit der wiedergegebenen akustischen Nutzsignale führen können.

Aus der DE 24 56 468 C3 ist eine elektroakustische Tonwiedergabeeinrichtung mit einem durch einen Störschalldetektor gesteuerten Verstärker bekannt, mit der sich durch eine Analyse der Störgeräusche Daten gewinnen lassen, mit deren Hilfe die wiederzugebenen akustischen Signale in ihrem Schallpegel und in ihrer Dynamik einzelner Frequenzbereiche so verändert werden, daß die Hörbarkeit und Verständlichkeit wesentlich verbessertwerden. Der Frequenzgang des NF-Verstärkers ist innerhalb des Tonfrequenzgebietes nicht konstant und weist in Abstimmung mit der Spektralverteilung des Störgeräusches bei solchen Frequenzen Anhebungen auf, bei denen das Störgeräusch die größte intensität besitzt. Eine derartige Schaltungsanordnung ist insbesondere wegen der zur Analyse des Störgeräschs erforderliche Mittel relativ aufwendig.

Aus DE-A-40 38 805 ist eine Vorrichtung zur Regelung der Lautstärke einer Tonsignalanlage zum Einbau in ein Kraftfahrzeug bekannt, bei der das Ausgangssignal eines im Kraftfahrzeuginnenraum angeordneten Mikrophons und der Pegel des wiederzugebenden Audiosignals zu einem Steuersignal zur Regelung der Wiedergabelautstärke verknüpft werden. Das Steuersignal wirkt auf eine digitale Kompressionsschaltung und einen elektronischen Rheostaten, die zusammen eine Veränderung der Wiedergabelautstärke bewirken. Außerdem wirkt das über einen Mikrocomputer geleitete Steuersignal auf eine Frequenzgangkompensationsschaltung ein, in der Frequenzkennlinien gespeichert sind, und bewirkt damit eine steuersignalabhängige Frequenzganganpassung. Diese bewirkt eine Anhebung tiefer Frequenzen, wobei davon ausgegangen wird, daß die zu kompensierenden Störgeräusche ein einseitig im Tiefpaßbereich liegendes Spektrum aufweisen.

Aus US-A-5 034 984 ist eine Lautstärkesteuerung für in einem Kraftfahrzeug betriebene Audiogeräte bekannt, bei der die Verstärkung eines hinsichtlich seines Verstärkungsfaktors variablen, im NF-Signalpfad angeordneten Verstärkers in Abhängigkeit eines aus der Fahrzeuggeschwindigkeit abgeleiteten Steuersignals gesteuert wird. Im Signalpfad zwischen NF-Quelle und Lautsprecher ist außer dem beschriebenen Verstärker, ein Lautstärkesteller mit integrierter Loudness-Funktion angeordnet, über den eine gewünschte Sollautstärke bzw. ein gewünschter Signal-Stör-Abstand einstellbar ist. Störgeräusch die größte Intensität besitzt. Eine derartige Schaltungsanordnung ist insbesondere wegen der zur Analyse des Störgeräusches erforderlichen Mittel relativ aufwendig.

US-A-5,204,971 offenbart eine zum Betrieb in einem Fahrzeug vorgesehene Audiosignal-Wiedergabevorrichtung mit einer störgeräuschabhängigen Lautstärkesteuerung. Dazu wird ein Störgeräusch im Fahrzeug mittels einer Mikrofons erfasst und aus dem Mikrofon-Ausgangssignal ein den Störgeräuschpegel repräsentierendes Signal erzeugt. In Abhängigkeit dieses Signals und zusätzlich einer voreingestellten Lautstärkewerts werden aus einer von mehreren Tabellen, in denen Geräuschpegelbereichen und Lautstärkevoreinstellungen Verstärkungswerte und werte für eine zusätzliche Bars-Anhebung zugeordnet sind, entsprechende Wertepaare ausgelesen und zur Einstellung des Audiosignalverstärkung und einer Barspegelanhebung verwendet. Die hierfür zu verwendende der mehreren Tabellen kann vom Benützer ausgewählt werden. Die verschiedenen Tabellen decken geringe oder starke Störgeraüschbeeinträchtigung sowie besonders leistungsfähige Audiosignalanlagen mit hoher Ausgangsleistung ab.

Der Erfindung liegt die Aufgabe zugrunde, eine wenig aufwendige Autoradio-Tonwiedergabeeinrichtung mit einer störgeräuschabhängigen Lautstärkes teuerung anzugeben, mit der sowohl der NF-Signalpegel als auch der Frequenzgang des NF-Signals verändert werden.

Diese Aufgabe wird erfindungsgemäß durch die im Anspruch 1 angegebenen Maßnahmen gelöst.

Die mit der Erfindung erzielten Vorteile bestehen insbesondere darin, daß die vorgeschlagene Tonwiedergabeeinrichtung mit sehr preiswerten elektrischen Bausteinen, die teilweise bereits in den Geräten vorhanden sind, auskommt. Da für jeden in Frage kommenden Kraftfahrzeug-Typ ein zugehöriges Kennlinienfeld bestimmbar ist, kann dieses bei der Erstellung des Gerätes eingespeichert werden bzw. bereits im Mikroprozessor vorgesehen sein. In besonders vorteilhafter Weise läßt sich nach Anspruch 2 der Frequenzgang und der Lautstärkepegel mit einem Equalizer verändern, zumal ein solcher bereits Bestandteil eines Autoradios sein kann. Die Wahl des Signalgebers hat den Vorteil, daß viele Kraftfahrzeuge bereits diesbezügliche Anschlußklemmen aufweisen. Mit Maßnahmen nach Anspruch 3 lassen sich Autoradios schnell und problemlos für diverse Kraftfahrzeug-Typen umrüsten.

Ein Ausführungsbeispiel der Erfindung ist als Prinzip-Blockschaltbild dargestellt und wird im folgenden näher erläutert.

in einem Autoradio 1 wird das von einem Empfangsteil 2 bzw. von einer NF-Quelle (z. B. Kassetten-Spieler, CD-Player) 3 gelieferte Nutzsignal in an sich bekannter Weise über einen im NF-Signalweg als Stellglied 4 vorgesehenen Equalizer und einen Verstärker 5 einem oder mehreren Lautsprechern 6 zugeführt. Der Equalizer wird von einem Mikroprozessor 7 gesteuert. Zur Ansteuerung des Mikroprozessors 7 ist beim vorliegenden Ausführungsbeispiel der Drehzahlmesser des Kraftfahrzeugmotors als Signal-Geber 8 vorgesehen. Im Mikroprozessor 7 ist ein zuvor ermitteltes, fahrzeug-typenbezogenes Kennlinienfeld gespeichert, mit dem der Mikroprozessor in Abhängigkeit von der Motordrehzahl n und/oder Fahrzeuggeschwindigkeit den Equalizer derart steuert, daß er den Frequenzgang und die Lautstärke L des Nutzsignals dahingehend verändert, daß die Hörbarkeit bzw. Sprachverständlichkeit einer akustischen Tonwiedergabe in Gegenwart von Störgeräuschen verbessert wird. Die für die vorgesehenen Kraftfahrzeug-typen ermittelten Kennlinienfelder können bereits bei der Fertigung des Autoradios eingespeichert werden. Austauschbare maskenprogrammierte Mikroprozessoren ermöglichen ein problemloses Umrüsten der Tonwiedergabeeinrichtungen.

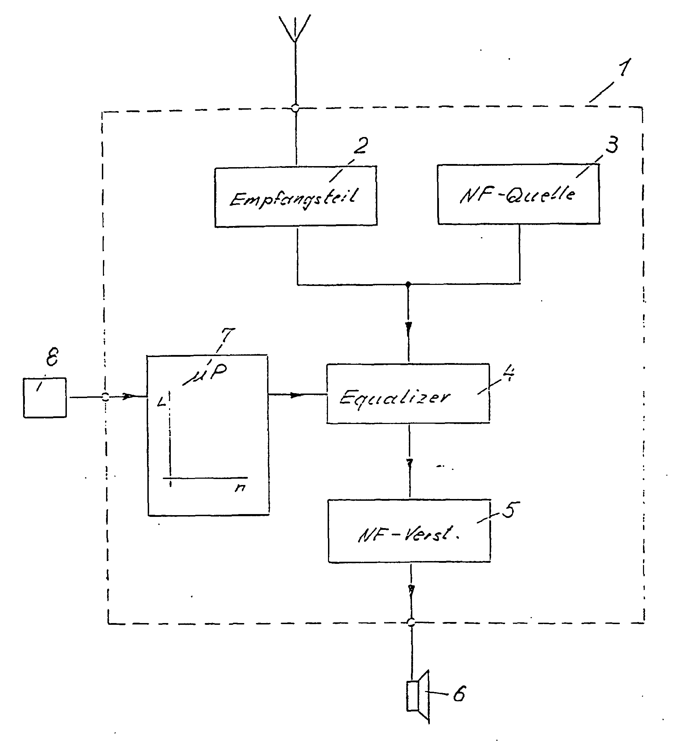

## Patentansprüche

1. Autoradio-Tonwiedergabeeinrichtung, in der externe Störgeräusche kompensiert werden, mit einem im NF-Signalweg vorgesehenen steuerbaren Stellglied (4), das in Abhängigkeit eines von einem elektrischen Signalgeber (8) erzeugten, von geschwindigkeits- und/oder drehzahlabhängigen Informationen eines Kraftfahrzeugs abgeleiteten Signals zur Steuerung der Lautstärke angesteuert wird, mit einem Mikroprozessor (7), in dem ein vorgegebenes fahrzeugtypbezogenes Kennlinienfeld von Frequenzgängen gespeichert ist, und der mittels des Stellgliedes (4) zusätzlich zur Lautstärke einen der jeweiligen Signalinformation des Signalgebers (8) zugeordneten Frequenzgang einstellt, und wobei als Signalgeber (8) der Geschwindigkeits- und/oder der Drehzahlmesser eines Kraftfahrzeugs dient.

2. Autoradio-Tonwiedergabeeinrichtung nach Anspruch 1, **dadurch gekennzeichnet, daß** als Stellglied (4) ein Equalizer vorgesehen ist.

3. Autoradio-Tonwiedergabeeinrichtung nach einem der Anspruche 1 bis 2, **dadurch gekennzeichnet, daß** der Mikroprozessor (7) gegen weitere, fahrzeugtypbezogene, maskenprogrammierte Prozessoren austauschbar ist.

## Claims

1. Car radio sound reproduction device in which external background noise is compensated for, having a controllable actuator (4) which is provided in the AF signal path and is driven on the basis of a signal which is produced by an electrical signal generator (8) and is derived from speed-dependent and/or rotation speed-dependent information for a motor vehicle, in order to control the volume,
having a microprocessor (7) which stores a prescribed vehicle type-related family of characteristic curves for frequency responses and uses the actuator (4) to set, in addition to the volume, a frequency response which is associated with the respective item of signal information from the signal generator (8), and where the signal generator (8) used is the speedometer and/or rev counter of a motor vehicle.

2. Car radio sound reproduction device according to Claim 1, **characterized in that** the actuator (4) provided is an equalizer.

3. Car radio sound reproduction device according to either of Claims 1 and 2, **characterized in that** the microprocessor (7) can be replaced with further, vehicle type-related, mask-programmed processors.

## Revendications

1. Installation de reproduction sonore d'autoradio à compensation de bruits externes, comprenant un organe de réglage (4) commandé dans le chemin du signal BF, et qui, en fonction d'informations dépendant de la vitesse et/ou du régime, générées par un générateur de signaux électriques (8) d'un signal déduit du véhicule, est commandée pour commander le volume sonore, comprenant un microprocesseur (7) contenant en mémoire les champs de caractéristiques des courbes de réponse en fréquence rapportées à des types de véhicules prédéterminés et qui, à l'aide de l'organe de réglage (4), règle en plus du volume sonore, une courbe de réponse en fréquence associée à l'information de signal respectif du générateur de signal (8), et dans laquelle le générateur de signal (8) est le capteur de vitesse et/ou de régime d'un véhicule automobile.

2. Installation de reproduction sonore d'autoradio selon la revendication 1,
**caractérisée en ce que**
l'organe de réglage (4) est un égaliseur.

3. Installation de reproduction sonore d'autoradio selon la revendication 1 ou 2,
**caractérisée en ce que**
le microprocesseur (7) peut être remplacé par d'autres processeurs programmés par masque et rapportés à un certain type de véhicules.
